# EUROPEAN PATENT APPLICATION

(11) **EP 0 905 835 A1**
(43) Date of publication of application: **31.03.1999**
(21) Application number: 98117567.2
(22) Date of filing: 16.09.1998
(51) Int. Cl.: H01S 3/085

(54) **Independently addressable vertical cavity surface emitting laser arrays with buried selectively oxidized native oxide aperture**

(30) Priority: 26.09.1997 US 938083
(71) Applicant: Xerox Corporation, Rochester, New York 14644 (US)
(72) Inventor: Sun, Decai, Sunnyvale, California 94087 (US)
(74) Representative: Grünecker, Kinkeldey, Stockmair & Schwanhäusser Anwaltssozietät

(57) **Abstract**

The present invention provides an independently addressable, high density, vertical cavity surface emitting laser/LED structure formed by a lateral oxidation process. The aperture of the laser structure is formed by either lateral wet oxidation or by both selective layer intermixing and lateral wet oxidation from a semi-annular groove etched in the laser structure. The same VCSEL array structure can be used for resonant vertical cavity LED array structures.

## Description

This invention relates to a monolithic semiconductor laser/LED and array thereof and, more particularly, to a independently addressable, high density, vertical cavity laser array using a native oxide layer for optical confinement and electrical isolation.

Monolithic arrays of solid state semiconductor lasers are very desirable light sources for high speed laser printing, optical fiber communications and other applications. Recently, there has been an increased interest in vertical cavity surface emitting lasers ("VCSEL's") although edge emitting lasers are currently used in the vast majority of applications. A common laser structure is a so-called "edge emitting laser" where light is emitted from the edge of a monolithic structure of semiconductor layers. A laser structure is a "VCSEL" where the light is emitted from the surface of the monolithic structure of semiconductor layers.

A reason for the interest in VCSEL's is that edge emitting lasers produce a beam with a large angular divergence, making efficient collection of the emitted beam more difficult. Furthermore, edge emitting lasers cannot be tested until the wafer is cleaved into individual devices, the edges of which form the mirror facets of each device. On the other hand, not only does the beam of a VCSEL have a small angular divergence, a VCSEL emits light normal to the surface of the wafer. In addition, since VCSEL's incorporate the mirrors monolithically in their design, they allow for on-wafer testing and the fabrication of one-dimensional or two-dimensional laser arrays.

With such laser arrays, it is desirable to position the VCSEL elements as densely as possible. However, closely spaced elements are difficult to electrically connect and to cool through heatsinking. Furthermore, closely spaced VCSEL elements tend to interact electrically, optically and/or thermally. These interactions, called "crosstalk", are usually undesirable.

Individually, VCSEL lasers are low power output devices. Arrays of VCSELs can be used to increase the power output and to simplify optical system design. To provide and maintain good optical alignment of the VCSEL elements of the array with one another and to minimize the assembly involved, arrays have been fabricated so that the VCSEL element are in a single semiconductor structure.

Another problem is making each individual laser element in the array independently addressable. As the laser elements are spaced closer together in higher densities, it is progressively more difficult to separately, individually and independently cause each element to emit light.

If the individual contacts that make the surface emitters of the array independently addressable are on the same side of the semiconductor structure as the light emitting surface, the lateral spacing between the surface emitting light sources is restricted and consequently the density of the array is limited. The diameter of the contact will be larger than the diameter of the emitting surface. Annular contact shapes are also more difficult to contact while maintaining a clear aperture for the emitting surface. For direct wire bonds, the contacts may require an auxiliary pad. Same surface contacts and emitting surfaces may also increase the amount of heat generated and may cause dissipation problems.

The individual contacts that make the surface emitters of the array independently addressable should also be directly aligned with the laser cavity. Alignment is advantageous because it minimizes the electrical resistance, the current spreading to each emitter, and the size of the electrode. It also places the heat-sinking as close to the emitting area as possible. Minimizing current spreading helps electrically isolate the individual laser elements.

A high aluminum content aluminum gallium arsenide (AlGaAs) semiconductor layer can be wet oxidized at high temperatures to form a stable, electrically isolating, optically confining semiconductor layer of native oxide, AlOₓ. AlGaAs is a common semiconductor layer in semiconductor lasers, including VCSELs.

An AlGaAs buried layer within a semiconductor structure can be laterally oxidized to form a buried aperture for optical and electrical confinement in VCSELs. The VCSEL diodes are fabricated individually. A circular or square mesa is defined by etching through the cap and confinement layers of a semiconductor structure down to the active region to expose an AlAs (or high Al content alloy) layer above the active region of the structure. Then, wet oxidation is conducted to convert the AlAs layer into a native oxide to form a small circular or square aperture for current confinement. The refractive index of the native oxide is around 1.6, lower than the refractive index of AlAs. The oxide aperture provides waveguiding laterally in the active region for optical confinement as well.

The p-contact layer for an electrode is directly deposited on top of the etched mesa. Since the mesa size has to be big enough to accommodate a big contact pad (on the order of 50 mm by 50 mm typically) for wire bonding, this structure makes prohibitive a closely spaced VCSEL array.

It is an object of the present invention to provide a monolithic, high density, independently addressable, VCSEL array structure with selectively oxidized native oxide layers.

The present invention provides an independently addressable, high density, vertical cavity surface emitting laser structure formed by a lateral oxidation process. The aperture of the laser structure is formed by either lateral wet oxidation or by both selective layer intermixing and lateral wet oxidation from a semi-annular groove etched in the laser structure.

Lateral selective wet oxidation can be conducted from a semi-annular etched groove to form an optical aperture. Alternately, layer disordering can define an intermixed region from an AlAs/AlGaAs heterostructure near the active region of a laser structure, then lateral selective oxidation is conducted from a semi-annular etched groove to form an optical aperture defined by the intermixed region.

The semi-annular groove preserves a planar surface section, which allows for an annular electrode connected to a contact pad. A native oxide layer can be used for electrical isolation of the VCSELs in an array. The same VCSEL array structure can be used for resonant vertical cavity LED array structures.
Figure 1 is a cross-sectional side view of the semiconductor layers of the VCSEL semiconductor structure of the present invention.
Figure 2 is a cross-sectional side view of the semiconductor layers of the VCSEL semiconductor structure of the present invention after etching.
Figure 3 is a cross-sectional side view of the VCSEL semiconductor structure of the present invention after etching and wet oxidation.
Figure 4 is a cross-sectional top view of the VCSEL semiconductor structure of the present invention after etching and wet oxidation.
Figure 5 is another cross-sectional side view of the VCSEL semiconductor structure of the present invention after etching and wet oxidation.
Figure 6 is a top view of the VCSEL semiconductor structure of the present invention.
Figure 7 is a cross-sectional side view of the semiconductor layers of a second embodiment of the VCSEL semiconductor structure of the present invention.
Figure 8 is a cross-sectional side view of the semiconductor layers of the second embodiment of the VCSEL semiconductor structure of the present invention after layer disordering.
Figure 9 is a top view of a linear array VCSEL semiconductor structure of the present invention.

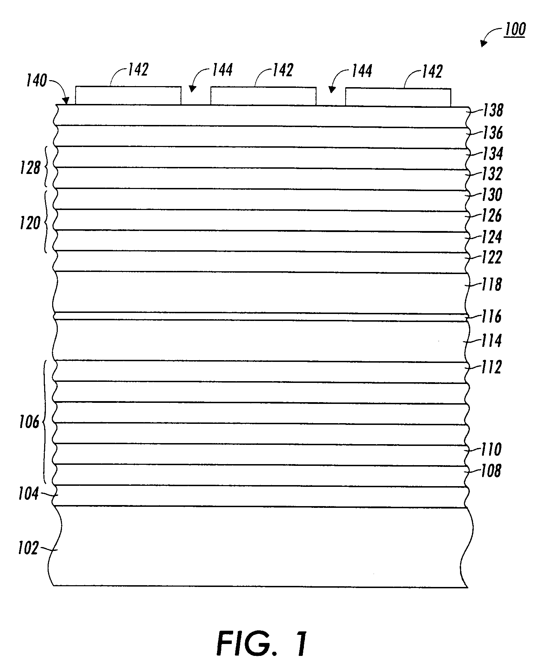

Figure 1 illustrates an independently addressable, high density, VCSEL array semiconductor structure 100 fabricated by lateral wet oxidation in accordance to the present invention. An n-type GaAs buffer layer 104 of approximately 200 nanometers is grown on an n-type GaAs substrate 102 using an epitaxial deposition process known as metal-organic chemical vapor deposition ("MOCVD"). The doping level of the n-type GaAs substrate 102 and GaAs buffer 104 are typically around the range of 3 × 10¹⁸ cm⁻³ to 7 × 10¹⁸ cm⁻³ so that a reasonably low resistance can be achieved in these layers. The semiconductor layers may also be deposited on the substrate by liquid phase epitaxy ("LPE"), molecular beam epitaxy ("MBE"), or other known crystal growth processes.

Above the GaAs buffer layer 104 is a superlattice structure for forming a lower distributed Bragg reflector ("DBR") 106 which provides the necessary internal reflection in a VCSEL structure. The lower DBR 106 is typically formed by multiple pairs of an AlGaAs layer 108 with a high aluminum content and another AlGaAs layer 110 with a low aluminum content. After the growth of a number of layer pairs, a final AlGaAs layer 112 with a high aluminum content is deposited before growing the first confinement layer 114 of the optical cavity.

A typical thickness of each layer pair 108 and 110 is approximately 120 nanometers for a laser emitting at 820 nanometers. The total thickness of each layer pair 108 and 110 is designed to be equal to one half of the optical wavelength at the intended wavelength of laser emission. The thickness of the final high aluminum content layer 112 is designed to be a quarter of the optical wavelength at the intended wavelength of laser emission. The AlGaAs layers 108 and 112 with a high aluminum content contain approximately 86% aluminum. The aluminum content of the AlGaAs layer with a high aluminum content should be sufficiently high to provide for a low refractive index, but not so high as to oxidize easily. The AlGaAs layer 110 with a low aluminum content has an aluminum content of approximately 16%. The composition of the AlGaAs layer with a low aluminum content should typically have sufficient aluminum so that it is non-absorptive at the lasing wavelength. It should also be sufficiently low so that the material achieves a desired refractive index.

Under this preferred embodiment, since light is emitted through the top surface of the semiconductor structure 100, the reflectivity of the lower DBR 106 should be as close to 100% as possible in order to achieve high internal reflection. High internal reflection generally reduces the threshold current of a laser. It is well-known that the reflectivity of the lower DBR 106 is generally a function of the difference in the refractive indices between the two AlGaAs layers of the superlattice and the number of layer pairs in the structure. The greater the difference in the refractive indices, the fewer number of pairs are required. Typically, 30 to 40 pairs of AlGaAs layers 108 and 110 are used to form the lower DBR structure 106.

After the lower DBR structure 106 has been deposited epitaxially, an AlGaAs confinement layer 114 is deposited. This lower AlGaAs confinement layer 114 has an aluminum content of about 58% and is n-type with a doping level of 1 × 10¹⁸ cm⁻³ to 5 × 10¹⁸ cm⁻³. Its thickness is approximately 100 nanometers. Above this AlGaAs confinement layer 114 is the active layer 116 of the laser structure which comprises of four quantum wells with a thickness of five to ten nanometers, separated by three barriers with a thickness of two to eight nanometers. Depending upon the desired output wavelength of the laser structure, pure GaAs or AlGaAs with a low aluminum content may be used to form the quantum well structures. Under this embodiment, these quantum wells are typically formed by undoped AlGaAs with an aluminum content of approximately 7%. Nothing in this invention prevents the use of a single quantum well or other multiple quantum well structures ("MQW") to form the active layer 116.

Above the active layer 116 is an upper AlGaAs confinement layer 118, which is structurally similar to the lower AlGaAs confinement layer 114 except for the polarity of its dopants. This upper confinement layer 118 has an aluminum content of about 58% but is p-type with a doping level of 1 × 10¹⁸ cm⁻³ to 4 × 10¹⁸ cm⁻³. Similar to the lower AlGaAs confinement layer 114, the thickness of top confinement layer 118 is also about 100 nanometers. These two AlGaAs confinement layers, 114 and 118, along with the active layer 116 generally form the optical cavity in which the desired optical gain can be attained. The total thickness of layers 114, 116, and 118 is adjusted to be equal to an integer multiple of the intended wavelength of laser emission.

Above the upper AlGaAs confinement layer 118 is an oxidation layer 120, which is used to form the laser aperture. The laser aperture controls the current flow and thus the lasing location in the active layer 116. The oxidation layer 112 can be located in another location further above the active layer 116 in the semiconductor structure.

The oxidation layer 120 consists of three semiconductor layers, an AlGaAs layer 122, an AlAs layer 124, and an AlGaAs layer 126. Each of these three layers 122, 124 and 126 in the oxidation layer 120 has a thicknesses of 25 nanometers. The aluminum content of the two AlGaAs layers, 122 and 126, is typically 40 percent. These three embedded layers allow for intermixing of layers using a layer disordering process. The total thickness of the oxidation layer 120 is a quarter wavelength of the light emitted by the active layer 116.

Typically, this oxidation layer 120 includes the first layer 126 of an upper DBR mirror.

Since the oxidized regions of the embedded layers which determine the current path are above the active layer, current confinement is improved. Generally, if the oxidized regions are located in a p-type region, current spreading effects are minimized because of the shorter diffusion length or lower mobility of holes under these circumstances.

After the oxidation layer 120 has been formed from the deposition of the AlGaAs layer 122, AlAs layer 124, and AlGaAs 126, the remainder of an upper DBR mirror 128 which contains p-type doping is deposited. The upper DBR mirror 128 is structurally similar to the lower DBR mirror 106 except for the polarity of its dopants. Additionally, the mirror layer closest to each side of the active region generally has a high aluminum content. In this embodiment, this high aluminum content layer 126 is also in the oxidation layer 120. In this embodiment, the reflectivity of the upper DBR 128 is typically 98% to 99% because light will be emitted through the surface of the semiconductor structure. The upper DBR 128 is typically formed by multiple pairs of an AlGaAs layer 130 with a high aluminum content and another AlGaAs layer 132 with a low aluminum content. Typically, 20 to 25 pairs of alternate AlGaAs 130 and 132 layers are used to form this upper DBR mirror 128.

After the growth of a number of layer pairs, a final quarter wavelength thick AlGaAs layer 134 with a high aluminum content is deposited before growing the cap and contact layers. Upon the upper p-DBR 128 is an AlGaAs layer 136, which typically has an aluminum composition of 45%, a thickness of 100 nanometers, and a magnesium doping level of approximately 5 × 10¹⁸ cm⁻³. This AlGaAs layer 136, along with a GaAs cap layer 138, facilitate the formation of ohmic contacts to the laser structure. The GaAs cap layer 138 is typically 100 nanometers with a magnesium doping of 1 × 10¹⁹ cm⁻³.

A silicon oxide layer 142 is deposited over the entire upper surface 140 of the semiconductor structure 100 as shown in Figure 1. The layer 142 has open window regions 144 through which the semiconductor structure will be etched. The window regions 144 form a semi-annular or c-shaped pattern in the silicon oxide alyer 142.

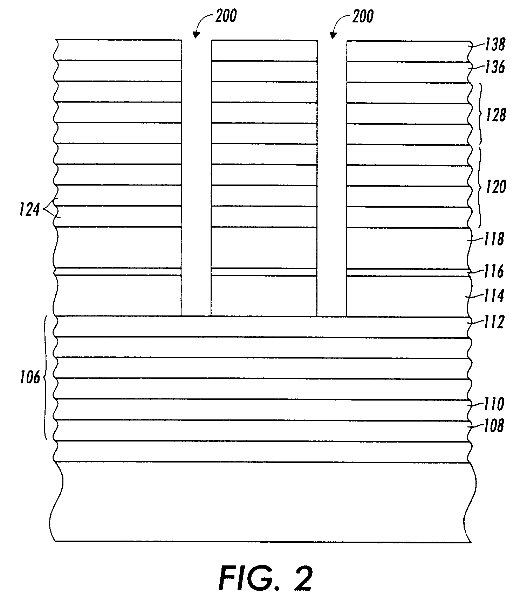

The semiconductor structure 100 is etched by a process such as reactive ion etching which provides for the formation of a semi-annular or c-shaped groove 200 with vertical sidewalls, as shown in Figure 2. The semi-circular groove 200 forms a pre-determined pattern which will later be used to define the resulting aperture of the laser structure 100.

The groove 200 is etched through the cap and contact layers 138 and 136, through the upper p-DBR 128, through the oxidation layer 120, through the upper confinement layer 118, the active layer 116, and through the lower confinement layer 114 to the upper semiconductor layer 112 of the lower n-DBR 106. The semi-annular groove 200 specifically exposes, along the sidewalls, in a semi-circle, the oxidation layer 120 and the AlAs layer 124 of the oxidation layer

The structure then undergoes an oxidation step in an environment with water vapor at a temperature of 400 to 450°C for approximately for an hour until the native oxidation encloses a circular region 202 of the AlAs layer 124.

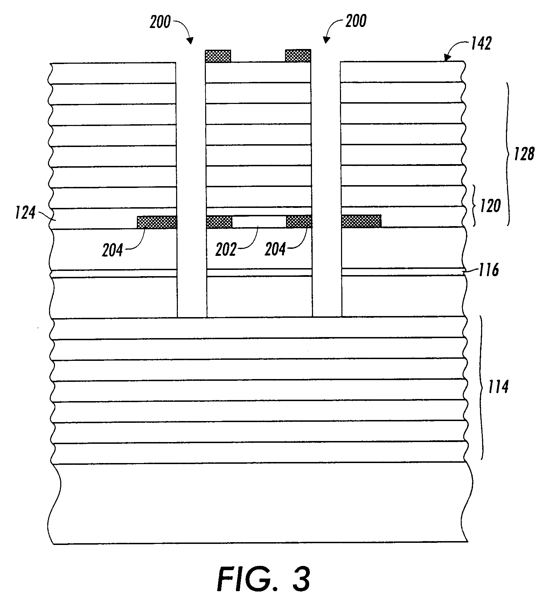

During the oxidation process, as shown in Figure 3, the oxidation layer 120 is exposed to the ambient through the groove 200. Thus, the oxidation layer 120, which comprises of AlGaAs with a high aluminum content, is oxidized radially inward from the groove 200 through the AlAs layer 124 towards the circular region 202 and radially outwards from the groove 200.

During the oxidation process, other layers in the structure remain essentially unoxidized since their aluminum content is lower. The oxidation rate of AlGaAs increases with the aluminum content in a generally exponential manner at constant temperature. Therefore, the layer that is being oxidized is the AlGaAs which has a high aluminum content of close to 95%.

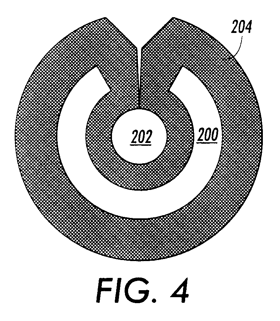

As shown in the side view of Figure 3 and the top view of Figure 4, after oxide formation, a native oxide layer 204 is formed from regions of the AlAs layer 124 of the oxidation layer 120. The native oxide layer 204 surrounds and defines the circular unoxidized region 202 which is the laser structure aperture. In addition, these boundaries are relatively smooth and sharp as they are defined by an epitaxial growth process and a photolithography process. Since the photolithography process has a high degree of accuracy, the spacing around the aperture can be minimal. Also, since these oxidized regions are defined after the epitaxial process has been completed, this approach allows for a high degree of process flexibility.

After the silicon nitride mask 146 has been removed, the aperture 202 is surrounded by the native oxide layer 204. The aperture 202 controls the current path through the active layer 116. Current flow through that portion of the active layer 116 which lies below the aperture 202 results in an injected density of p-type and n-type carriers, resulting in optical amplification. At sufficiently high current flow, this optical amplification, in combination with feedback from the DBR mirrors, 114 and 128, will result in laser oscillation and emission within aperture 202 through the surface 142 of the laser structure 100.

Either during the etching of the grooves 200 or in a separate etching step, the contact and cap layers 136 and 138 are removed from the surface 142 of the semiconductor structure 100 in the area near the aperture 202 exposing the upper AlGaAs layer 134 prior to oxidation.

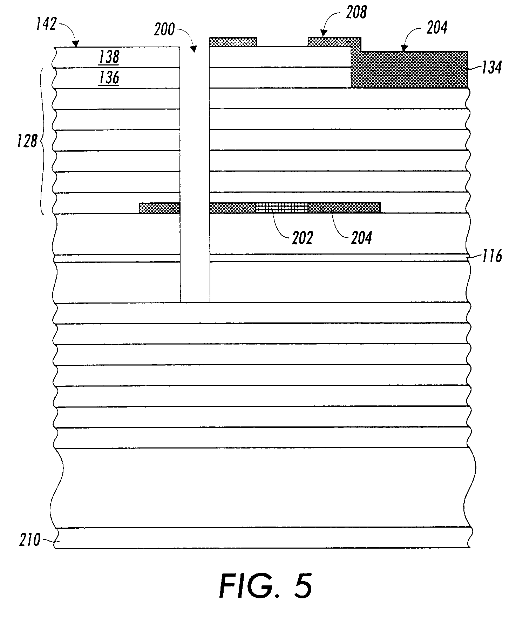

As shown in Figure 5, the upper AlGaAs layer 134 of the upper p-DBR 128 is also converted to a native oxide layer 204 during the oxidation process. This layer 204 is highly resistive and electrically isolating. Metal contacts 208 and 210 are formed on the surface 142 of the contact/cap layers 136 and 138 and the bottom side of the substrate respectively for biasing the laser. A typical material used for forming the contacts is a titanium/gold bilayer film.

The electrode 208 outside the oxide aperture region 202 lays on top of the native oxide layer 204. The current is confined to flow into the active region 116 through the aperture 202 above the active region, preventing leakage current elsewhere. Although the electrical isolation can be achieved by shallow proton ion implantation, the surface oxide approach is easier and more economic.

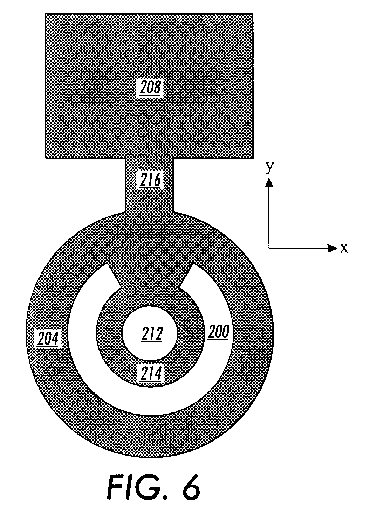

Figure 6 shows a top view of the VCSEL laser structure. The upper native oxide layer 204 provides an electrically isolating circular pad. Within the native oxide layer 204 is the semi-annular groove 200. Within the groove 200 is the circular surface emission region 212 where the VCSEL emits light. Surrounding the emission region 212 but within the groove 200 is the annular electrode 214. An interconnect electrode stripe 216 connects the annular electrode 214 to a contact pad 218. The stripe 216 extends through the open end 220 of the semi-annular groove 200. The annular electrode 214, the interconnect electrode stripe 216 and the contact pad 218 form the upper electrode 208 of the laser structure 100.

The annular portion 214 of the electrode allows light to be emitted from the laser through the center of the annular portion. Again, a typical material used for forming the contacts is a titanium/gold alloy.

The use of a semiannular groove to form the native oxide layer deep within the laser structure preserves a planar upper surface for the electrode while still allowing the electrode to contact the active region within the laser.

If a transparent semiconductor material is used for the electrode, the electrode may cover the emission region 212. A typical transparent semiconductor used is indium tin oxide ("ITO") deposited by a sputtering process. The use of transparent semiconductors allows for the formation of even more compact laser devices since the spacing between VCSELs may be smaller.

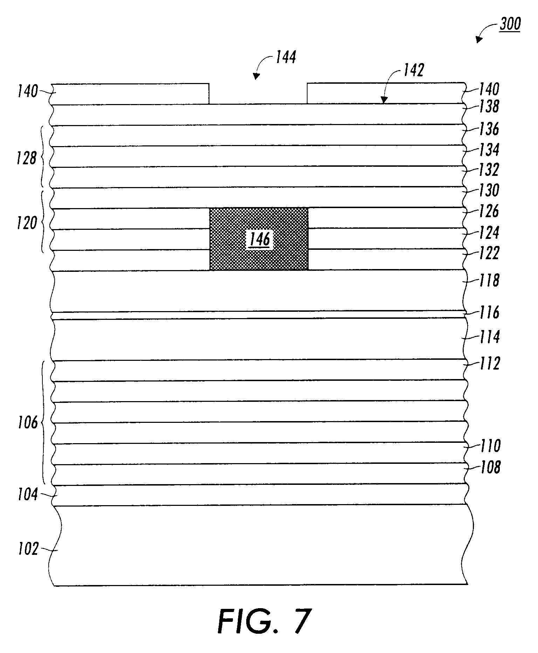

The semiconductor structure 300 of Figure 7 illustrates another embodiment of the independently addressable, high density, VCSEL array semiconductor structure 100 of Figure 1 except that the semiconductor structure 300 is fabricated by selective layer intermixing and lateral wet oxidation in accordance to the present invention.

The semiconductor structure 300 of Figure 7 has the same semiconductor layers as the semiconductor structure 100 of Figure 1 with a few changes to the layers. The semiconductor structure 300 has an n-type GaAs substrate 102, an n-type GaAs buffer layer 104, a superlattice structure of a lower n-DBR 106 formed by multiple pairs of an AlGaAs layer 108 with a high aluminum content and another AlGaAs layer 110 with a low aluminum content with a final AlGaAs layer 112 with a high aluminum content, a lower AlGaAs confinement layer 114, the active layer 116, an upper AlGaAs confinement layer 118, and an oxidation layer 120 of an AlGaAs layer 122, an AlAs layer 124, and an AlGaAs layer 126.

The first distinction between the semiconductor structure 300 and the structure 100 is that each of the three layers 122, 124 and 126 in the oxidation layer 120 has a magnesium doping of approximately 5 × 10¹⁸ cm⁻³.

The magnesium acts as the disordering agent which enables intermixing by an impurity induced layer disordering (IILD) process. The AlGaAs layer 122, AlAs layer 124, and AlGaAs 126 form the embedded layers for the IILD process.

After the oxidation layer 120 has been formed from the deposition of the AlGaAs layer 122, AlAs layer 124, and AlGaAs 126, the structure 300 has an upper p-DBR formed by multiple pairs of an AlGaAs layer 130 with a high aluminum content and another AlGaAs layer 132 with a low aluminum content and a final AlGaAs layer 134 with a high aluminum content, and the cap and contact layers of an AlGaAs layer 136 and a GaAs layer 138.

In the formation of semiconductor structure 300 of Figure 7, prior to the oxidation process is a layer disordering process.

To form a laser using the semiconductor structure 300, silicon nitride caps 140 are deposited on the upper surface 142 of the cap layer 138 except for a window region 144. In this case, since p-type dopants are used to induce layer disordering, the silicon nitride caps 140 cover the surface 142 except for the window regions 144 below which the oxidation layer will be layer disordered. The regions 146 below the window regions 144 to be oxidized are part but not all of the oxidation layer 120.

The embedded disordering agent is created by the dopants in the AlAs layer 124. During the IILD process, intermixing of the Group III elements, gallium and aluminum, occurs in the region 144 not covered by the silicon nitride cap 140.

It is well-known that IILD can be used to intermix Group III atoms in a III-V semiconductor heterostructure as shown in U.S. Patent No. 5,386,428, entitled "Stacked Active Region Laser Array For Multicolor Emission," by Thornton et al. It is also well-known that zinc or beryllium diffused under gallium-rich or arsenic-deficient conditions can be used to produce p-type disordering. A discussion of such a process can be found in U.S. Patent No. 5,376,583, entitled "Method for Producing P-Type Impurity Induced Layer Disordering" by Northrup et al. Therefore, impurity-induced layer intermixing using a variety of impurity sources is well known. Under this embodiment, a layer disordering process is used to define the regions within which oxidation can occur. In other words, a layer disordering process is performed prior to the oxidation process. During this pre-oxidation disordering process, the Group III elements of the layers in the heterostructure intermix, altering the aluminum composition of each layer.

During the intermixing process, the aluminum composition decreases in the layer which originally had a high aluminum content while the aluminum composition increases in the layer with a low aluminum content. After a typical IILD process, the region of the AlAs layer 124 without the silicon nitride mask 140 has an aluminum content of less than 100% while at the same time, regions in the AlGaAs layers 122 and 126 have a higher aluminum content. This process depends upon the difference in the aluminum mole fractions of two regions--the region in which oxidation is desired and the region in which oxidation is not desired. In other words, this invention does not depend upon the absolute aluminum mole fractions of the two regions. Since the oxidation rates in aluminum-containing semiconductors generally depend upon the aluminum mole fraction in an exponential manner, this process tends to be very reproducible. Consequently, the yield of the lasers formed by the present invention should be higher.

The intermixing introduces gallium into or removes aluminum from the AlAs layer 124, thus lowering its aluminum mole fraction. Likewise, the intermixing introduces aluminum into or removes gallium from the AlGaAs layers 122 and 126, increasing their aluminum mole fractions. Minimal intermixing of Group III elements occurs under the areas capped by silicon nitride 138 since the silicon nitride prevents the arsenic from escaping. This approach allows for the intermixing of some interfaces without intermixing others above, below or next to them. The silicon nitride cap 140 is used to define the boundaries of the intermixed region 144 in a direction perpendicular to the surface of the substrate. Generally, it has been observed that a relatively sharp interface is created between the intermixed and the unintermixed region. Since the regions of the heterostructure which would be intermixed are defined by the placement of an embedded disordering agent in the structure, highly localized intermixing can be accomplished. Other sources which can cause layer disordering include other p- or n-type impurities as well as Group III or V vacancies.

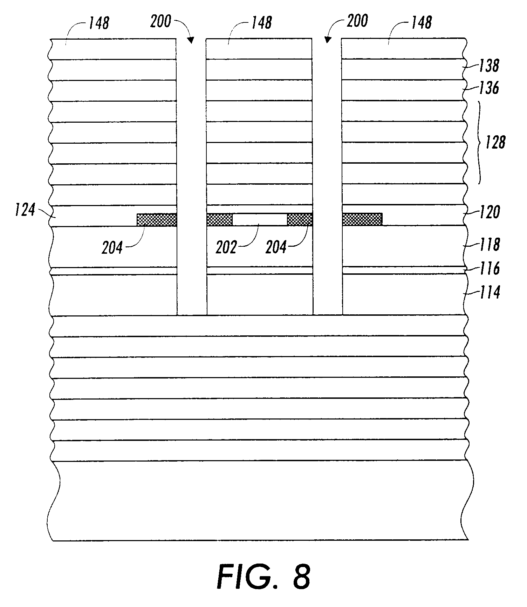

After the layer disordering process is completed, the silicon nitride caps 140 are removed and an another, different patterned, silicon oxide layer 148 is deposited over the entire upper surface 142 of the semiconductor structure 100 as shown in Figure 8.

The semiconductor structure 300 is etched in the same manner as the semiconductor structure which provides for the formation of a semi-annular or c-shaped groove 200 with vertical sidewalls.

The groove 200 is etched through the cap and contact layers 138 and 136, through the upper p-DBR 128, through the oxidation layer 120, through the upper confinement layer 118, the active layer 116, and through the lower confinement layer 114 to the upper semiconductor layer 112 of the lower n-DBR 106. The semi-annular groove 200 specifically exposes, along the sidewalls, in a semi-circle, the oxidation layer 120 and the AlAs layer 124 of the oxidation layer.

The structure then undergoes an oxidation step in an environment with water vapor at a temperature of 400 to 450°C for approximately for an hour until the native oxidation encloses the intermixed circular region.

During the oxidation process, the oxidation layer 120 is exposed to the ambient through the groove 200. Thus, the oxidation layer 120, which comprises of AlGaAs with a high aluminum content, is oxidized radially inward from the groove 200 through the unintermixed region towards the intermixed region 202 and radially outwards from the groove 200.

At this point, there exists a difference between the mole fraction of intermixed regions 202 of the AlAs layer 124 and the remaining unintermixed regions of the AlAs layer 124. The difference in aluminum mole fraction creates a disparity in the oxidation rates since the oxidation rate of AlGaAs depends exponentially upon the aluminum mole fraction. For instance, the oxidation rate of AlAs is about 1.5 µm per minute at 450°C and is about 0.05 µm per minute for AlGaAs with about 80 percent aluminum. Due to this significant difference in the oxidation rates between the intermixed regions 202 and the remaining unintermixed regions of the AlAs layer 124, the oxidation process slows down substantially when it reaches the interface between the intermixed and unintermixed regions.

The native oxide layer 204 surrounds and defines the circular intermixed region 202 which is the laser structure aperture.

The semiconductor structure 300 is then processed exactly like the semiconductor structure 100 with the formation of electrodes as detailed in Figures 3, 4, 5 and 6 and accompanying text.

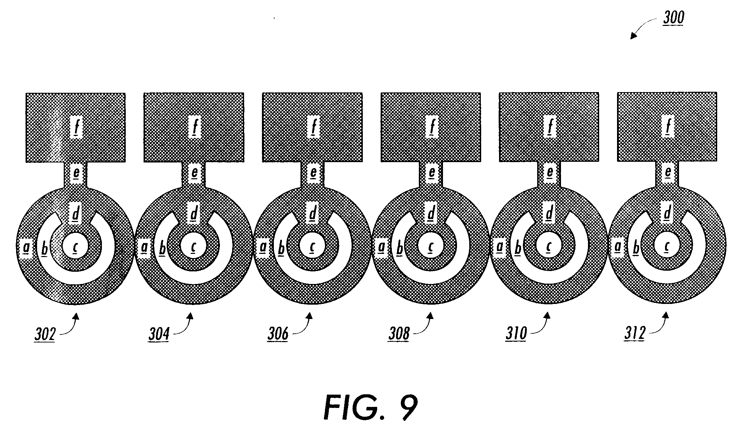

Figure 9 shows a top view of a VCSEL array structure 300. The individual VCSEL described previously can be repeated to form an array. In this embodiment, six VCSELs 302, 304, 306, 308, 310 and 312 are arranged linearly. Each VCSEL has a native oxide layer a, a semi-annular groove b, an aperture and emission area c, an annular electrode d connected by an interconnect electrode stripe e to a contact pad f. The stripe e extends through the open end g of the semi-annular groove b. Each electrode is independently addressable and the native oxide layers a make the individual VCSELs in the array electrically isolated from each other. The current is confined to flow into the active region through the oxide aperture above the active region, preventing leakage current elsewhere. The spacing between two adjacent VCSELs can be on the order of 10 µm depending upon the aperture size of each VCSEL. The multiple VCSELs in the array can be arranged in a staggered pattern or other high density patterns.

The independently addressable, high density array semiconductor structure of the present invention with its aperture fabricated by selective layer intermixing and lateral wet oxidation is not limited to a laser array. Resonant vertical cavity light emitting diodes (LED) can also be the light emitting elements of the invention. The resonant vertical cavity LED structure is the same as a VCSEL structure except that the reflectivity of the top and bottom distributed Bragg reflection mirrors in a resonant cavity LED need not to be as high as the 99% required by a VCSEL.

The composition, dopants, doping levels, and dimensions given above are exemplary only, and variations in these parameters are permissible. Additionally, other layers in addition to the ones shown in the figures may also be included. Variations in experimental conditions such as temperature and time are also permitted. Lastly, instead of GaAs and GaAlAs, other semiconductor materials such as GaAlSb, InAlGaP, or other III-V alloys may also be used.

## Claims

1. A surface emitting laser/LED comprising:
a substrate;
a plurality of semiconductor layers formed on said substrate;
one or more of said plurality of semiconductor layers forming an active region;
a first reflector located above said active region and a second reflector located below said active region, at least one of said reflectors allowing a partial transmission of light emitted by said active region;
an aperture which controls current flowing through said active region, said aperture defined by a native oxide layer, said native oxide layer surrounding a semi-annular groove formed in said plurality of semiconductor layers; and
first and second electrodes which enable biasing of said active region.

2. The surface emitting laser/LED of Claim 1 wherein said first reflector and/or said second reflector is a distributed Bragg reflector.

3. The surface emitting laser/LED of Claims 1 or 2 further comprising a second native oxide layer wherein a portion of said first electrode is on said second native oxide layer.

4. The surface emitting laser/LED of any of Claims 1 to 3 wherein said plurality of semiconductor layers comprises a Group III-V arsenide material, and or an aluminum containing semiconductor layer for forming said aperture.

5. The surface emitting laser/LED of any of Claims 1 to 4 wherein said aperture is an unoxidized region in an aluminum containing semiconductor layer embedded in said plurality of semiconductor layers.

6. The surface emitting laser/LED of any of Claims 1 to 5 wherein said first electrode is transparent to said light emitted from said active region.

7. The surface emitting laser/LED of any of Claims 1 to 6 wherein said aperture is formed of an intermixed region of said plurality of semiconductor layers.

8. The surface emitting laser/LED of Claim 7 wherein said intermixed region is formed by a layer disordering process.

9. An array of surface emitting lasers/LEDs comprising a plurality of said surface emitting lasers/LEDs according to any of the claims 1 to 6.
